(19) Europäisches Patentamt
European Patent Office
Office européen des brevets

(11) **EP 4 757 182 A1**

(12) **EUROPEAN PATENT APPLICATION**
published in accordance with Art. 153(4) EPC

(43) Date of publication:
**10.06.2026 Bulletin 2026/24**

(21) Application number: **23947356.4**

(22) Date of filing: **21.11.2023**

(51) International Patent Classification (IPC):
*H03K 3/57* (2006.01)

(52) Cooperative Patent Classification (CPC):
**G21B 1/05; G21B 1/21; H02J 7/00; H02J 7/34; H03K 3/57; H05B 6/64**

(86) International application number:
**PCT/CN2023/133018**

(87) International publication number:
**WO 2025/025418 (06.02.2025 Gazette 2025/06)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.08.2023 CN 202310966017**

(71) Applicant: **Shanghai Startorus Fusion Technology Company Limited
Shanghai 201808 (CN)**

(72) Inventors:
• **WANG, Shouzhi**
Xi'an, Shaanxi 710075 (CN)
• **CHEN, Rui**
Xi'an, Shaanxi 710075 (CN)
• **TAN, Yi**
Xi'an, Shaanxi 710075 (CN)

(74) Representative: **Valet Patent Services Limited
c/o Caya 83713X
Am Börstig 5
96052 Bamberg (DE)**

(54) **HIGH VOLTAGE POWER SUPPLY, MICROWAVE SOURCE AND MICROWAVE HEATING SYSTEM**

(57) Embodiments of the present application provide a high voltage power supply, a microwave source and a microwave heating system, where the high voltage power supply includes a Marx generator configured to output a high voltage pulse, where the Marx generator includes N Marx modules, N is a positive integer greater than 1, each of the Marx modules includes an energy storage capacitor, an all-solid-state switch and a drive module, and in the Marx module, the drive module is powered by the energy storage capacitor to drive the all-solid-state switch; a charging circuit, connected to the Marx generator and configured to charge the energy storage capacitor; and a control system, connected to the Marx generator and configured to control a charging process and a discharging process of the Marx generator.

FIG. 1

**Description**

**TECHNICAL FIELD**

The present application relates to the field of power electronic technology, in particular to a high voltage power supply, a microwave source and a microwave heating system.

**BACKGROUND**

In the thermonuclear fusion technology, plasma is generally required to be heated to a sufficiently high reaction temperature. In an ohmic heating method as a traditional heating method, a resistivity of the plasma gradually decreases as a temperature of the plasma rises, and thus a heating efficiency decreases. In this case, a desired reaction temperature cannot be reached only with the ohmic heating method, and an auxiliary heating method is required.

At present, for a small magnetic confinement apparatus, such as a tokamak apparatus with a ring field of about 0.1 T, it is usually possible to use electron cyclotron resonance (ECR) as an auxiliary heating method, and a required corresponding microwave source is usually 2.45 GHz; however, the use of ECR for the auxiliary heating of the plasma in the tokamak apparatus requires a stable microwave source, which not only requires that a high voltage pulsed power supply used is capable of discharging stably, but also requires high-speed turn-on and turn-off capabilities to match a duration of the plasma or a stable plateau period. However, turn-on and turn-off time scales of an existing high voltage power source are usually on a level of seconds, which makes it impossible for the existing microwave source to achieve precise time control during a discharging process of the above tokamak apparatus. Therefore, how to make the microwave source better meet the requirements of a time scale of thermonuclear fusion has become an urgent technical problem to be solved.

**SUMMARY**

The present application provides a high voltage power supply, a microwave source, and a microwave heating system capable of enabling a microwave source to meet the requirements of a time scale of thermonuclear fusion, and thus to heat plasma to a sufficiently high reaction temperature.

Some embodiments of the present application provide a high voltage power supply, including: a Marx generator configured to output a high voltage pulse, where the Marx generator includes N Marx modules, N is a positive integer greater than 1, each Marx module includes an energy storage capacitor, an all-solid-state switch and a drive module, and in the Marx module, the drive module is powered by the energy storage capacitor to drive the all-solid-state switch;

a charging circuit, connected to the Marx generator and configured to charge the energy storage capacitor; and
a control system, connected to the Marx generator and configured to control a charging process and a discharging process of the Marx generator.

Other embodiments of the present application provide a microwave source, including: a microwave generator and a microwave transmission line; where the microwave generator includes a cathode configured to supply hot electrons and the above high voltage power supply, and is configured to apply an electric field to drive movement of electrons to generate hot electrons for forming a microwave oscillation; and the microwave transmission line is connected to an output end of the microwave generator and configured to output the microwave oscillation.

Other embodiments of the present application further provide a microwave heating system, including: the above microwave source, where the microwave source is configured to couple the plasma in a thermonuclear reaction apparatus to heat the plasma.

As can be seen, in the above solution, the high voltage power supply of the microwave source used to carry out auxiliary heating of the plasma of thermonuclear fusion uses the Marx generator, in which the all-solid-state switch is capable of realizing high-speed turn-on and turn-off, and by adjusting a triggering signal of the solid-state switch, a stable discharge plateau period matching a stable plateau period of the plasma can be accurately realized to meet the requirements of the time scale of thermonuclear fusion.

Further, the microwave source can further be made to meet the higher transient power requirements of the thermonuclear fusion by adjusting the voltage of each Marx module in the Marx generator of the above high voltage power supply.

In addition, by self-powering the drive module of the all-solid-state switch with the energy storage capacitor in this Marx module, there is no need for isolation between the all-solid-state switch in each Marx module, and therefore, there is no need to design a complicated power supply circuit, and the structure is simpler. Moreover, the self-powering of the drive module of the all-solid-state switch using the energy storage capacitor can continuously provide a continuous quasi-steady state power supply. Furthermore, in the present application, due to the self-powering of the drive module by using the energy storage capacitor, this drive module can continuously consume the energy of the energy storage capacitor, the energy of the energy storage capacitor is reduced to a safe level, and the high voltage exists during an operating period while the high voltage does not exist during a non-operating period, and thus passive safety is realized.

## BRIEF DESCRIPTION OF THE DRAWINGS

The drawings herein are incorporated into the specification and form a part of the specification to illustrate embodiments consistent with the present application. The drawings are further used to explain the principle of the present application in conjunction with the specification.

In order to more clearly illustrate the technical solutions in the embodiments of the present application or in the prior art, the drawings used in the description for the embodiments or the prior art are briefly described below. Apparently, those skilled in the art may obtain other drawings according to these drawings without creative work.

FIG. 1 is a schematic structural diagram of a high voltage power supply according to some embodiments of the present application;

FIG. 2 is a schematic structural diagram of a Marx module according to an embodiment of the present application;

FIG. 3 is a schematic structural diagram of a Marx generator according to an embodiment of the present application;

FIG. 4 is a schematic diagram showing a charging state of a high voltage power supply according to an embodiment of the present application;

FIG. 5 is a schematic diagram showing a discharging state of a high voltage power supply according to an embodiment of the present application;

FIG. 6 shows a schematic structural diagram of a high voltage power supply according to other embodiments of the present application;

FIG. 7 shows a schematic structural diagram of a microwave generator in a microwave source according to an embodiment of the present application;

FIG. 8 shows a schematic structural diagram of a microwave transmission line in a microwave source according to an embodiment of the present application;

FIG. 9 is an oscillogram output by a microwave source according to an embodiment of the present application; and

FIG. 10 is a schematic oscillogram of microwave source output power scanning and detector measurement according to an embodiment of the present application.

## DETAILED DESCRIPTION

In order to make those ordinarily skilled in the art better understand solutions provided in the present application, the technical solutions in the embodiments of the present application are described below clearly and completely with reference to the drawings in the embodiments of the present application. Apparently, the described embodiments are only a part of the embodiments of the present application and not all of the embodiments. All other embodiments obtained by those ordinarily skilled in the art based on the embodiments provided in the present application without creative work shall fall within the scope of protection of the present application.

It should be noted that, terms such as "first", "second" used in the specification, and the claims and the drawings of the present application are intended to distinguish similar objects from each other and not define a particular order or sequence. It should be understood that, the data used in such a manner may be interchangeable where appropriate, so that the embodiments of the present application described herein may be implemented in an order other than those illustrated or described herein. In addition, the terms such as "including", "having" and any variations thereof are intended to cover non-exclusive inclusion. For example, a process, a method, a system, a product or an apparatus including a series of steps or units is not limited to those steps or units that are clearly listed, and may include other steps or units that are not clearly listed or that are inherent to the process, the method, the product or the device.

As described above, using electron cyclotron resonance for auxiliary heating of plasma of a tokamak apparatus requires a stable microwave source, and the microwave power is essentially derived from a drift motion of electrons, so its output power is sensitive to the high voltage input, and therefore a high voltage pulsed power supply is required to be able to discharge stably; and the current research on the tokamak apparatus is still at an experimental stage, and the duration of its plasma is relatively short, for example, about 20ms, with a stable plateau period of about 10ms, therefore, the high voltage pulsed power supply should have a high-speed turn-on and turn-off capability to match the duration of the plasma or the stable plateau period. However, the high voltage power supply in the prior art is often based on twelve-pulse rectification, which not only cannot meet the higher transient power of the tokamak apparatus in terms of transient output power, but also has a turn-on and turn-off time scale on the level of seconds, which makes it difficult to achieve an accurate time control.

Some other high voltage pulsed power supplies, such as an all-solid-state Marx generator, have a high-speed turn-on and turn-off capability, however, an all-solid-state switch in the all-solid-state Marx generator is not in the same potential, the power supply needs to solve the problem of isolation of high and low potentials, the power supply of each circuit to isolate from each other and other issues, and usually a design of the steady-state isolation of power supply is very difficult. In order to reduce the difficulty of isolation between the power supply of the all-solid-state switch, the power supply and trigger of a drive circuit often use the same circuit, and the power supply and trigger using the same circuit can only provide transient power supply, so that a pulse width of a high voltage pulse of the Marx generator in the prior art is often transient, which usually at the nanosecond level or the microsecond level. However, the plasma duration of the present application is stabilized for a plateau period of about 10ms. Therefore, in the present application, the high voltage power supply is required to have a steady-state or quasi-steady-state output in milliseconds, for example, the high voltage power supply is required to output a high voltage pulse with a quasi-steady state pulse width of 5-10ms. It is often difficult for the all-solid-state Marx generator in the prior art to meet the requirements of the high voltage power supply for the microwave source for the heating performed by the plasma of the tokamak apparatus of the present application.

Based on this, a high voltage power supply is provided in the present embodiment. This high voltage power supply is configured to provide a negative high voltage to a microwave source for auxiliary heating of plasma in a thermonuclear fusion process, so as to drive the drift motion of electrons, so that a microwave oscillation is generated to heat the plasma in the tokamak apparatus. Specifically, in the embodiment of the present application, the above tokamak apparatus may be a SUNIST tokamak apparatus.

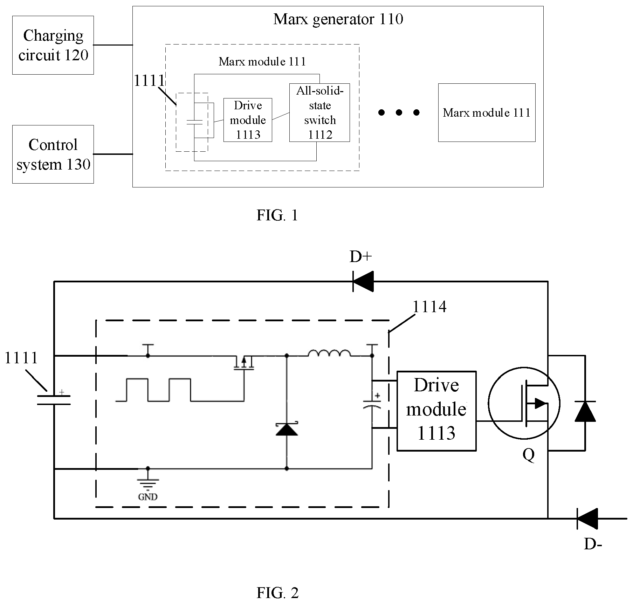

FIG. 1 shows a schematic internal structural diagram of a high voltage power supply according to an embodiment of the present application. As shown in FIG. 1, this high voltage power supply may include: a Marx generator 110, a charging circuit 120, and a control system 130.

The above Marx generator 110 has N Marx modules 111 configured to output a high voltage pulse, where N is a positive integer greater than 1. In the embodiment of the present application, each Marx module 111 may include: an energy storage capacitor 1111, an all-solid-state switch 1112, and a drive module 1113. The above drive module 1113 is powered by the energy storage capacitor 1111 in this Marx module, and is configured to trigger the all-solid-state switch 1112 to be turned on or turned off.

The above charging circuit 120 is connected to the above Marx generator 110, and is configured to charge the above energy storage capacitor 1111.

The above control system 130 is connected to the above Marx generator 110, and is configured to control a charging process and a discharging process of the above Marx generator 110.

In the present application, the high voltage power supply of the microwave source used to carry out auxiliary heating of the plasma of thermonuclear fusion uses the Marx generator, in which the all-solid-state switch is capable of realizing a high-speed turn-on and turn-off, and by adjusting a triggering signal of the solid-state switch, a stable discharge plateau period matching a stable plateau period of the plasma can be accurately realized to meet the requirements of the time scale of thermonuclear fusion. By self-powering the drive module of the all-solid-state switch using the energy storage capacitor in this Marx module, there is no need for isolation between the all-solid-state switch in each Marx module, and therefore, there is no need to design a complicated power supply circuit, and the structure is simpler. Moreover, the self-powering of the drive module of the all-solid-state switch by using the energy storage capacitor can continuously provide a continuous quasi-steady state power supply. Furthermore, in the present application, due to the self-powering of the drive module by using the energy storage capacitor, this drive module can continuously consume the energy of the energy storage capacitor, the energy of the energy storage capacitor is reduced to a safe level, and the high voltage exists during an operating period while the high voltage does not exist during a non-operating period, and thus passive safety is realized.

In some embodiments of the present application, the above all-solid-state switch 1112 may use a fully-controlled device. For example, the above all-solid-state switch 1112 may use a GTR, an IGBT, a MOSFET, or a Darlington transistor.

In some embodiments of the present application, the above energy storage capacitor 1111 may use an electrolytic capacitor. Exemplarily, the above energy storage capacitor 1111 may use an electrolytic capacitor of 400V/10mF. In this case, a single Marx module 111 operates at a voltage of 400 V. The above energy storage capacitor 1111 may also use another electrolytic capacitor of course, the voltage and the capacitance of which may be selected based on the requirements of the microwave source.

As an exemplary embodiment, one end of the above all-solid-state switch 1112 is connected to a high potential, and the other end of the all-solid-state switch is connected to a low potential. The above low potential end may generally function as a reference potential end, for example, an end grounded or an end connected to a potential in the circuit. In some embodiments of the present application, a reference potential end of the above all-solid-state switch 1112 is connected to a negative electrode of the energy storage capacitor 1111 and is connected to the same potential in the circuit, for example, to be grounded.

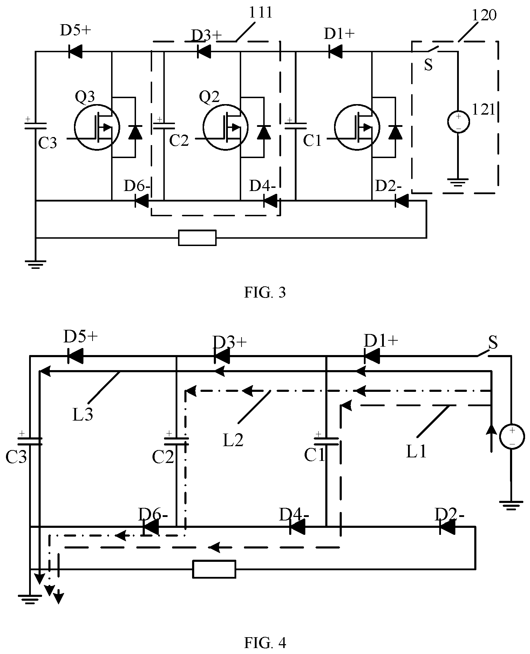

FIG. 2 shows a schematic structure of a Marx module according to an embodiment of the present application. FIG. 3 shows a schematic structure of a Marx generator according to an embodiment of the present application. It should be noted that FIG. 2 and FIG. 3 take that the above all-solid-state switch 1112 adopts IGBT as an example to illustrate, and the above IGBTs are labeled as Q, Q2, or Q3 in FIG. 2 and FIG. 3. As shown in FIG. 2 and FIG. 3, an emitter electrode of the IGBT is directly connected to the negative electrode of the energy storage capacitor in this Marx module via a wire. In this way, in the process of the energy storage capacitor supplying the power to the drive module for this IGBT, all the potentials in this Marx module can be at the same level, thereby achieving more stable voltage detection and current protection and avoiding false triggering or device destruction due to inconsistent potentials. If other types of solid-state switches are used, the reference potential end thereof may be directly connected to the negative electrode of the energy storage capacitor.

In a case that the above Marx generator 110 is required to be charged, the control system 130 controls the all-solid-state switch 1112 respectively in each Marx module 111 to be turned off and controls the charging circuit 120 to charge the energy storage capacitor 1111. In this case, the energy storage capacitor 1111 in each Marx module is connected in parallel with each other. When the above Marx generator 110 discharges, the control system 130 controls all-solid-state switches 1112 of a corresponding number of Marx modules 111 to be turned on based on a voltage requirement of the microwave source. In this case, the energy storage capacitors 1111 in the above corresponding number of Marx modules 111 are connected in series to output a corresponding voltage.

As an exemplary embodiment, the following description is given with a capacitor of 450V/10mF, which operates at a voltage of 400V. For example, a high voltage power supply outputs a voltage of approximately 13KV and a current of 2A, and in this case, 33 to 35 Marx modules are required to be connected in series with each other. In this way, the capacitance of the high voltage power supply is calculated as C=10mF/33=0.3mF, and a voltage drop of discharging 10ms is expressed as follows.

$$\frac{I_{OUT} \cdot t}{C_{Connected\ in\ series}} = \frac{2A \times 10ms}{0.3mF} = 67V$$

In this case, the voltage drop with respect to 13KV is calculated as $\frac{67V}{13kV} = 5\%$ .

Where $I_{OUT}$ represents an output current; $C_{Connected\ in\ series}$ represents an equivalent capacitance of the discharging; and t represents a required high voltage pulse width, that is, a discharging duration.

It can be seen that, the high voltage power supply provided in the present application realizes a 10ms discharge window, and its voltage drops to 5%, which can achieve a relatively stable discharge window period.

In the above embodiment, the high voltage power supply provided in the present application is exemplarily illustrated to provide a stable high voltage pulse matching the stable plateau period of the plasma. If the pulse width of the high voltage pulse is required to be increased, a capacitor having a larger capacitance may be selected to reduce the requirement for voltage fluctuation of the high voltage pulse.

In some embodiments of the present application, as shown in FIG. 2, the Marx module 111 may further include a circuit 1114 for supplying power for the drive module, an input end of which is connected to the energy storage capacitor 1111, and an output end of which is connected to the drive module 1113, for converting the voltage of the energy storage capacitor 1111 to the supply voltage of the drive module 1113.

Exemplarily, the above circuit 1114 for supplying power for the drive module may use a direct current conversion circuit to convert the voltage of the energy storage capacitor 1111 to the supply voltage of the drive module 1113. As an exemplary embodiment, the above direct current conversion circuit may use a buck voltage reduction circuit to convert the voltage of the 400V energy storage capacitor 1111 to the 24V voltage required by the drive module 1113. In the present embodiment, the input and output of the direct current conversion circuit may be determined based on the voltage value of the selected energy storage capacitor 1111 and the voltage value required by the drive module 1113. For example, the energy storage capacitor 1111 may be used with a voltage such as 450V/500V/700V, and the drive module 1113 may be used with a driving voltage of 12V/15V, which is not limited in the present embodiment.

Since the voltage of the energy storage capacitor 1111 is variable during the discharging process, in order to ensure that a continuous power supply can be provided to the drive module 1113, in an embodiment, the circuit 1114 for supplying power for the drive module may be selected as a wide-range input direct current conversion circuit. In this way, during the continuous discharging process of the energy storage capacitor 1111, even if the voltage of the energy storage capacitor 1111 decreases, the direct current conversion circuit is able to continuously output the voltage required by the drive module 1113.

In some embodiments of the present application, as shown in FIG. 2 and FIG. 3, the all-solid-state switch 1112 of each Marx module 111 is connected in parallel with the energy storage capacitor 1111, and the all-solid-state switch 1112 is at the input end of the Marx module 111 and the energy storage capacitor 1111 is at the output end of the Marx module 111.

When it is necessary to discharge, the all-solid-state switch 1112 in this Marx module 111 is turned on, and the current flows out from the positive electrode of a previous energy storage capacitor 1111 and flows through this all-solid-state switch 1112 to reach the negative electrode of this energy storage capacitor 1111, and if the all-solid-state switch 1112 in the next Marx module 111 is also in a state of being turning on, after reaching the negative electrode of this energy storage capacitor 1111, the current flows out from the positive electrode of this energy storage capacitor 1111, this energy storage capacitor 1111 is output in series with the previous energy storage capacitor 1111, and if the all-solid-state switches 1112 in the N Marx modules 111 are all turned on, then it is output in series with the N-1 energy storage capacitors 1111. Thus, arbitrary high voltage pulses can be output simply by increasing or decreasing the level number of the Marx generator 110.

In one embodiment, as shown in FIG. 3 (taking a 3 Marx modules 111 as an example to illustrate), the Marx module 111 further includes: a first diode D+ and a second diode D-, and the all-solid-state switch 1112 includes an IGBT transistor Q; a negative electrode of the first diode D+ is connected to a positive electrode of the energy storage capacitor 1111, and a positive electrode of the first diode D+ is connected to the input end of the Marx module 111 via a collector of the IGBT transistor Q; and a negative electrode of the second diode D- is connected to a negative electrode of the energy storage capacitor 1111 via the collector of the IGBT transistor Q, and a positive electrode of the second diode D- is connected to the input end of the Marx module 111.

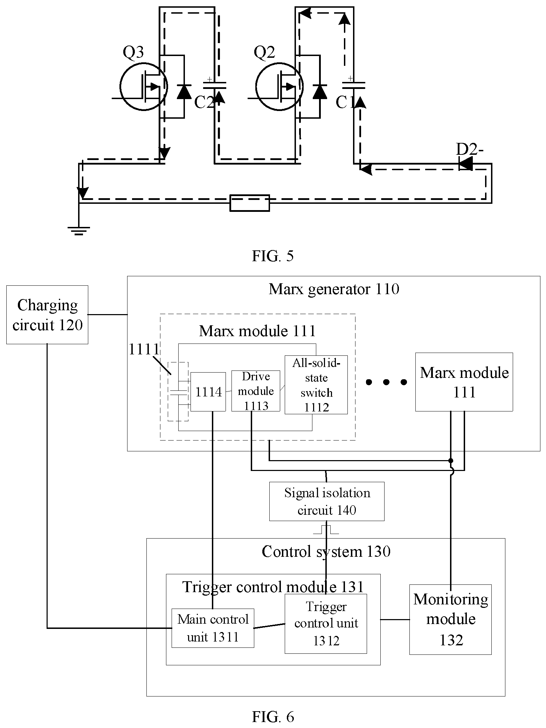

The charging process and the discharging process are explained below with reference to FIG. 4 and FIG. 5 (taking the 3 Marx modules 111 as an example to illustrate):

Referring to FIG. 4, during charging, the all-solid-state switch 1112 in each Marx modules 111 is turned off, and the current flows out of the direct current charging power supply 121 and is divided into three charging branches in parallel (referring to the parallel branches shown by arrows in FIG. 4), where a first parallel branch L1 is: the current flows into a positive electrode of a first-level energy storage capacitor C1 via a first-level first diode D1+, flows out of a negative electrode of the first-level energy storage capacitor C1, and flows into the ground via a second-level second diode D4- and a third-level second diode D6- to charge the first-level energy storage capacitor C1; a second parallel branch L2 is: the current flows into a positive electrode of a second-level energy storage capacitor C2 via the first-level first diode D1+ and the second-level first diode D3+, flows out of a negative electrode of the second-level energy storage capacitor C2, and flows into the ground via a third-level second diode D6- to charge the second-level energy storage capacitor C2; and a third parallel branch L3 is: the current flows into a positive electrode of a third-level energy storage capacitor C1 via the first-level first diode D1+, the second-level first diode D2+ and the third-level first diode D3+, and flows into the ground via the negative electrode of the third-level energy storage capacitor C3 to charge the third-level energy storage capacitor C3. A final energy storage capacitor voltage at each level is that a charging voltage minus 3 times of a diode voltage drop. Therefore, charging voltages of the energy storage capacitors of each level are the same during the charging process, and each Marx module 111 is in a uniform state.

The following is a 450V/10mF capacitor, which operates at a voltage of 400V, and a charging current of 5A, it is connected in series with a 33 Marx modules, so that an equivalent capacitance capacity when charging in parallel is: C=10mF×33=0.33F, and its charging time is:

$$\frac{V_{single} \cdot C_{connected\ in\ parallel}}{I_{IN}} = \frac{400V \times 0.33F}{5A} = 27S$$

Where $I_{IN}$ is the charging current, $C_{Connected\ in\ parallel}$ is the equivalent capacitance capacity of charging, and $V_{single}$ is an operating voltage of a single capacitor.

The above embodiments are only exemplary to illustrate the charging time of the high voltage power supply of the present application, and the charging current can be further increased if the charging time needs to be shortened.

Referring to FIG. 5, during discharging, the first diode D+ and the second diode D- in each Marx module 111 are inversely cut off, a second-level all-solid-state switch Q2 is turned on as well as a third-level all-solid-state switch Q3 is turned on, the current flows out of the positive electrode of the first-level energy storage capacitor C1, after passing through the second-level all-solid-state switch Q2, the current reaches the negative electrode of the second-level energy storage capacitor C2 and flows out of the positive electrode of the second-level energy storage capacitor C2, and after passing through the third-level of all-solid-state switch Q3, the current flows through a load and form a loop from a first-level second diode D2-, and then get twice the direct current charging power supply 121 voltage to realize the high voltage pulse output. In the present embodiment, the microwave source can set up corresponding levels for the negative high voltage requirements to meet the requirements of the microwave source. A specific discharging process can be described in the formula of the discharging process listed in the above embodiment.

In an embodiment, the charging circuit 120 includes a direct current charging power supply 121 and a charging control switch S. A control end of the charging control switch S is connected to the control system 130 and is turned on upon the triggering of a charging instruction output from the control system 130 to conduct the charging circuit, and is turned off upon the triggering of a charging stop instruction output from the control system 130 to turn off the charging circuit.

In the present embodiment, the charging control switch S may use a high voltage switch, for example, a power switching transistor such as an IGBT, MOSFET, etc. may be used. When charging is required, the control system 130 may control the charging control switch S to be turned on, thereby conducting the charging circuit, and when discharging is required, the control system 130 may control the charging control switch S to be turned off to prevent the negative high voltage pulse from shocking the direct current charging power supply 121 during the discharging of the Marx generator 110.

In an embodiment, referring to FIG. 6, the control system 130 may include a control module 131 connected to the driving circuit via a signal isolation circuit 140 for outputting a trigger signal to the driving circuit. Since each all-solid-state switch 1112 operates at different potentials and is high voltage level, the trigger signal of each solid-state switch needs to be isolated, and in the present embodiment, the signal isolation circuit may use a fiber-optic isolator, or an optocoupler isolation circuit for isolating each trigger signal.

In the present embodiment, the control module 131 may include a main control unit 1311 and a trigger control unit 1312, where the main control unit 1311 is connected to the charging control switch S for controlling the direct current charging power supply 121 to output and stop outputting by controlling the charging control switch S. The main control unit 1311 is further connected to the circuit 1114 for supplying power for the drive module for controlling the circuit 1114 for supplying power for the drive module to supply power to the drive module 1113.

The main control unit 1311 is further connected to the trigger control unit 1312 for controlling the trigger control unit 1312 to enable the trigger control module 131 to control a triggering timing of each solid-state switch in the Marx generator 110.

In an embodiment, the control system 130 may further include a monitoring module 132, which is connected to each Marx module 111 respectively for collecting a state signal of the Marx module 111, for example, collecting a charging current signal, a discharging current signal, a real-time voltage signal and the like of the Marx module 111, and transmitting the state signal in real time to a controller. The controller may detect whether each Marx module 111 is in an overcurrent/overvoltage state in real time based on the charging current signal, the discharging current signal and the voltage signal, and when in the overcurrent/overvoltage state, a corresponding Marx module 111 may be controlled to exit via the trigger control module 131. Exemplarily, when the overcurrent occurs in a certain Marx module 111 during the discharging process, the trigger control module 131 may control this all-solid-state switch 1112 to be turned off, and the discharging current no longer passes through the previous storage capacitor 1111 and this solid-state switch, and is connected in series with this storage capacitor 1111 via this second diode D-. Discharge may continue to be performed.

In an embodiment, the monitoring module 132 may include a measurement unit and a monitoring unit, where the measurement unit may use an isolated current sensor, an isolated voltage sensor, a wireless temperature sensor and the like to detect in real time a voltage/current and temperature state of each Marx module 111 and the Marx generator 110 and upload the voltage/current and temperature state in real time to the control module 131. The monitoring unit may monitor each Marx module 111 and the Marx generator 110 based on an isolated sensor, for example, the wireless temperature sensor, a voltage sensor camera and the like, and a program interface displaying the voltage of the high voltage power supply module as well as the temperature of the high voltage power supply and environmental information.

In an embodiment, the isolated sensor, for example, a wireless temperature sensor, a wireless voltage sensor, a wireless current sensor and the like, can detect the state signal such as voltage/current/temperature of each Marx module 111 and the Marx generator 110 in real time, and transmit the state signal to the control module 131 by means of isolated transmission.

In an embodiment, since the plasma duration of the tokamak apparatus is about 20ms and the stable plateau period is about 10ms, in order to satisfy the plasma duration of the tokamak apparatus, in the present embodiment, the control system 130 needs to have a predetermined time control precision, and exemplarily, the time precision of the main control unit 1311 may be of the level of seconds, and since the high voltage power supply needs to have a high-speed turn-on and turn-off capability, the trigger control unit 1312 needs a time precision on the level of microseconds to ensure that the high voltage power supply can accurately provide the negative high voltage pulse required by the microwave source.

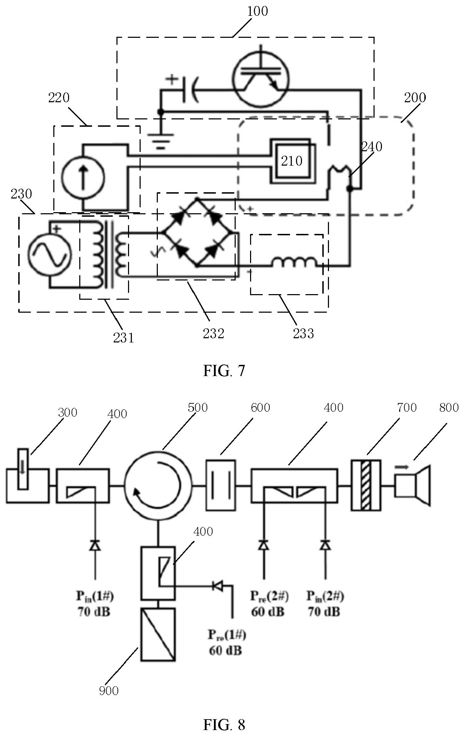

Embodiments of the present application further provide a microwave source system. In the embodiments of the present application, the above microwave source system may include a microwave generator and a microwave transmission line, where the microwave transmission line is connected to an output end of the microwave generator. FIG. 7 shows a schematic structure of the microwave generator in the microwave source according to the embodiments of the present application. FIG. 8 shows a schematic structure of the microwave transmission line in the microwave source according to the embodiments of the present application. As shown in FIG. 7, the microwave generator may include a cathode 240 for providing hot electrons, and a high voltage power source 100 as described in the above embodiments, which may apply an electric field to drive electrons to move to generate microwaves.

In the present embodiment, the above microwave generator is illustrated by taking a magnetron 200 as an example:

The magnetron 200 may include an anode for providing an axial magnetic field and a cathode 240 for providing hot electrons; the high voltage power supply 100 is applied between the anode and the cathode 240 to form a radial electric field. Where the hot electrons are emitted from the cathode 240 and moved toward the anode driven by the radial electric field between the cathode 240 and the anode, and the hot electrons are subjected to the axial magnetic field during the movement and generate a drift motion. During the drift movement, the electrons induce positive charges on one side of a resonant cavity slit, which is equivalent to charging a slit capacitance, the slit capacitance and a cavity inductance produce LC resonance, and a charge polarity on both sides of the slit exhibits a periodic change, which in turn affects a flow direction of the electrons from the cathode 240, ultimately forming a rotating wheel pendulum line orbit.

The LC resonance and the electronic movement are coupled to reach a stable state, and the frequency of this resonance is an operating frequency of the magnetron 200. A metal ring or wire is provided at the output end of the microwave generator as an output end connected to a microwave transmission line to export the microwave oscillations in the resonant cavity to the microwave transmission line, which transmits the energy generated by the microwave generator to an antenna, and ultimately couples into the plasma for auxiliary heating of the plasma.

In an embodiment, the electromagnet 210 generates a stable axial magnetic field, and during operation, a resistance of the electromagnet 210 increases as the temperature rises, and in order to provide the stable axial magnetic field, in the present embodiment, the electromagnet power supply 220 adopts a constant-current power supply, and exemplarily, a constant-current power supply with an operating current of about 7A may be used.

In an embodiment, the cathode power supply 230 supplies power to the cathode 240 to generate hot electrons, and the cathode 240 operates at a higher potential, therefore, the cathode power supply 230 needs to be isolated to supply power, and in the present embodiment, an isolation transformer 231 may be used to supply power. As shown in FIG. 7, an alternating current power is transformed via the isolation transformer 231 to convert the alternating current power voltage to the voltage required by the cathode 240, and rectified and filtered via the rectifier circuit 232 and the filter circuit 233. In the present embodiment, the rectifier circuit 232 may use a full-bridge rectifier circuit or a half-bridge rectifier circuit. The filter circuit 233 may use an inductive filtering. Via the rectifying circuit 232 and the filtering circuit 233, fluctuations in the current of the cathode 240 can be reduced, thereby reducing an effect on the power of the microwave source caused by fluctuations in the current of the cathode 240.

In an embodiment, the alternating current power source may use an alternating current power source with an adjustable voltage, for example, it may be adjustable between 230V-250V. An output voltage of the isolation converter may be about 10V and the cathode 240 current may be about 50A.

In an embodiment, since the plasma duration of the tokamak apparatus is about 20ms and the stable plateau period is about 10ms, the microwave output is only about 10ms, which is a short time window, and it is difficult to realize the feedback adjustment of the cathode 240 current based on the output power of the microwave source. Therefore, in the present embodiment, the cathode power supply 230 is required to supply a continuous steady-state current, for example, to maintain the cathode 240 current stably at 50A. The steady-state operating current will cause thermal deposition to the rectifier circuit 232, the filter circuit 233, the cathode 240 and other devices. Therefore, in the present embodiment, the cathode 240 and the cathode power supply 230 are installed with water cooling and/or air cooling to sufficiently cool the cathode 240 and the cathode power supply 230 to prevent the heat deposition from affecting a stable output of the microwave source.

In an embodiment, as shown in FIG. 8, the microwave transmission line includes: an excitation cavity 300, a circulator 500, a direct current blocker 600, a ceramic window 700, an antenna 800 that are sequentially connected, and a water load 900 connected to the circulator; and a directional coupler 400 is connected to at least one of: a position between the excitation cavity 300 and the circulator 500, a position between the direct current blocker 600 and the ceramic window 700, and a position between the circulator 500 and the water load 900.

Specifically, the excitation cavity 300 is configured to convert a microwave oscillation signal of a coaxial output of the microwave generator into a mode of a propagated signal in a waveguide. The directional coupler 400 can measure a microwave power of a transmission path, and in the present embodiment, three sets of directional couplers can be provided to measure two sets of incident power and two sets of reflected power, with directional coupling ratios of 70dB and 60dB, respectively, and the detector uses a linear detector; the circulator 500 is configured to avoid that the reflected power of a subsequent microwave transmission line enters the microwave generator, and making it to be absorbed by the water load; and the direct current blocker 600 is configured to isolate an electrical connection between the microwave generator and the tokamak apparatus. Since a grounding point of the high voltage power supply 100 and a grounding point of the load are not in one place, a potential of a wall of the tokamak apparatus will change during the discharging process of the high voltage power supply 100. In order to protect various diagnostics on the side of the tokamak apparatus, and at the same time to ensure that a measurement on a side of the microwave generator is not affected by the plasma, the electrical connection between the two can be turned off via the direct current blocker; the ceramic window 700 serves to isolate the atmosphere and the high vacuum while allowing the microwave to pass through without loss; and the antenna 800 emits the microwave in the waveguide in a directional manner, and its coupling to the vacuum cavity is optimized by adjusting the radial position of the antenna.

In an embodiment, based on the above microwave source and the high voltage power supply 100 in the above embodiment, the electromagnet 210 operates at a current of 6.4A, an input voltage of the cathode power supply power supply is 230V, the voltage of a single Marx module 111 in the high voltage power supply 100 is 375V, the input voltage of the high voltage power supply 10 is about -13kV, and the output current is 1.4A; and according to an energy conversion efficiency estimated to be 80%, the microwave source output power is about 14.6kW, which is difficult to satisfy the transient power of the microwave source (more than 30kW) required by the tokamak apparatus.

It has been found that the current of the electromagnet 210, the input voltage of the cathode 240, and the voltage of each Marx module 111 of the high voltage power supply 100 may have a relatively large effect on the output power of the microwave source, and therefore, the output power of the microwave source can be adjusted by adjusting the current of the electromagnet 210, the input voltage of the cathode 240, and the voltage of each Marx module 111 of the high voltage power supply 100.

In the present embodiment, the power supply of the electromagnet 210 may be a constant current power supply with adjustable current, the cathode power supply 230 may be an alternating current power supply with an adjustable voltage, and the direct current charging power supply 121 in the high voltage power supply 100 has an adjustable charging voltage, and thus, the module voltage of each Marx module 111 is adjustable.

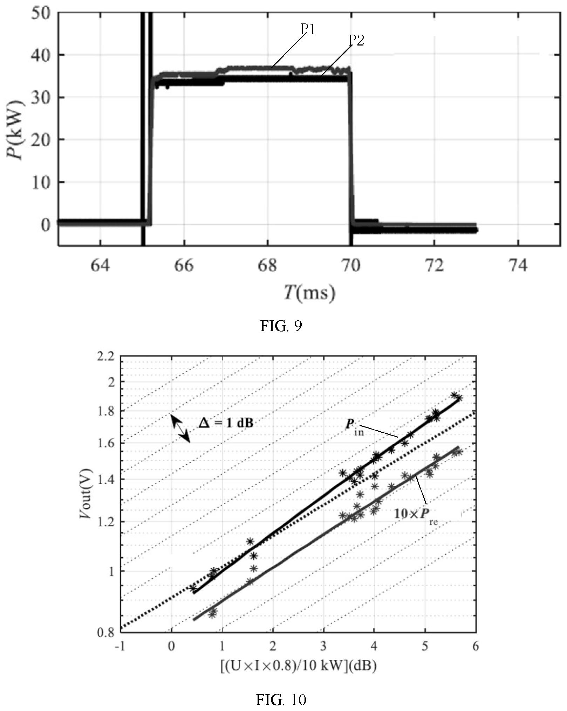

The output power of the microwave source is adjusted to 30KW or above by adjusting the current of the electromagnet 210, the input voltage of the cathode 240, and the voltage of each Marx module 111 of the high voltage power supply 100. Exemplarily, the operating current of the electromagnet 210 can be adjusted to 6.6A, the input voltage of the cathode power supply 230 is adjusted to 250V, the voltage of the single Marx module 111 of the high voltage power supply 100 is adjusted to 385V, the high voltage output by the high voltage power supply 100 is about -13.5kV, and the output current is 3A (referring to the formula for the calculation of the discharging time in the above embodiments, the output current is 3A, and if the voltage drop of the discharging process is satisfied to be about 5% or less than 5%, a sustained discharge time can be within 5-7ms), and according to an energy conversion efficiency estimated to be 80%, the microwave source output power is about 32.4kW, and the specific input waveform is shown in FIG. 9.

The output width set in FIG. 9 is 5ms, which can be specifically controlled by the timing of the output trigger signal via the trigger control module 131. During an output period of the pulse width, the microwave maintains a stable high power output, with an output power of about 35kW, which can be referred to the first waveform P1 in FIG. 9; the microwave power measured via the directional coupler is about 37kW, which can be referred to the second waveform P2 in FIG. 9, with an error of 6% between the two, which can meet the requirement of the transient power (30kW or above) required by the tokamak apparatus.

In the present embodiment, the output power of the microwave source can be scanned by simultaneously scanning an operating current of the electromagnet 210, an input voltage of the cathode power supply 230 and a voltage of the single Marx module 111 of the high voltage power supply 100, that is, the output power of the microwave source can be scanned, and the scanned result is as shown in a first fitting curve Pre in FIG. 10. The output power of the microwave source can be output in a range of 10kW to 35kW, an error of a second fitting curve Pin obtained with the measurement result of the directional coupler is less than 1dB, and at the same time, a reflected power is less than 1/10 of the incident power, and a coupling between the antenna and the vacuum cavity is good.

Embodiments of the present application further provide a microwave heating system including the microwave source in the above embodiment, where a relatively high microwave power is generated via a microwave generator and coupled to the plasma via a microwave transmission line, thereby heating the plasma.

The above is only a preferred embodiment of the present application, and it should be noted that for those ordinarily skilled in the art, a number of improvements and embellishments may be made without departing from the principles of the present application, and these improvements and embellishments shall also be regarded as the scope of protection of the present application.

**Claims**

1. A high voltage power supply, comprising:

   a Marx generator configured to output a high voltage pulse, wherein the Marx generator comprises N Marx modules, N is a positive integer greater than 1, each Marx module comprises an energy storage capacitor, an all-solid-state switch and a drive module, and in the Marx module, the drive module is powered by the energy storage capacitor to drive the all-solid-state switch;
   a charging circuit, connected to the Marx generator and configured to charge the energy storage capacitor; and
   a control system, connected to the Marx generator and configured to control a charging process and a discharging process of the Marx generator.

2. The high voltage power supply according to claim 1, wherein in each Marx module, the all-solid-state switch is connected in parallel with the energy storage capacitor.

3. The high voltage power supply according to claim 1 or 2, wherein a reference potential end of the all-solid-state switch is connected to a negative electrode of the energy storage capacitor and is at a same potential as the negative electrode of the energy storage capacitor.

4. The high voltage power supply according to claim 2, wherein the control system is configured to:

control all-solid-state switches respectively in the N Marx modules to be turned off and control the charging circuit to charge energy storage capacitors respectively in the N Marx modules in a case that the Marx generator is required to be charged; and

control all-solid-state switches of a corresponding number of Marx modules among the N Marx modules to be turned on based on a voltage requirement of a microwave source in a case that the Marx generator is required to be discharged, so that the corresponding number of energy storage capacitors are connected in series to output a voltage corresponding to the voltage requirement.

5. The high voltage power supply according to claim 1, wherein the Marx module further comprises:
a circuit for supplying power for the drive module, wherein an input end of the circuit is connected to the energy storage capacitor, an output end of the circuit is connected to the drive module, and the circuit is configured to convert a voltage of the energy storage capacitor into a supply voltage of the drive module.

6. The high voltage power supply according to claim 1, wherein the all-solid-state switch comprises one of a GTR, an IGBT, a MOSFET, or a Darlington transistor.

7. The high voltage power supply according to claim 6, wherein in a case that the all-solid-state switch comprises the IGBT,

the Marx module further comprises: a first diode and a second diode, wherein

a negative electrode of the first diode is connected to a positive electrode of the energy storage capacitor, and a positive electrode of the first diode is connected to a collector electrode of the IGBT and a positive input end of the Marx module; and

a negative electrode of the second diode is connected to an emitter electrode of the IGBT, a positive electrode of the first diode is connected to a negative output end of the Marx module, and the emitter electrode of the IGBT is connected to a negative electrode of the energy storage capacitor.

8. The high voltage power supply according to claim 1, wherein the control system comprises:

a controller, connected to the drive circuit via a signal isolation circuit and configured to output a trigger signal to the drive circuit; and

a monitoring module, configured to acquire a state signal of the Marx module and transmit the state signal to the controller.

9. The high voltage power supply according to claim 1, wherein the charging circuit comprises a direct current charging power supply and a charging control switch, wherein

a control terminal of the charge control switch is connected to the control system; and

the charging control switch is turned on to connect the charging circuit in response to a charging instruction outputted by the control system, and the charging control switch is turned off to disconnect the charging circuit in response to a charging stop instruction outputted by the control system.

10. A microwave source, comprising:

a microwave generator, configured to apply an electric field to drive movement of electrons to generate hot electrons for forming a microwave oscillation, wherein the microwave generator comprises a cathode configured to supply the hot electrons and the high voltage power supply according to any one of claims 1 to 9; and

a microwave transmission line, connected to an output end of the microwave generator and configured to output the microwave oscillation.

11. The microwave source according to claim 10, further comprising:
a cathode power supply, configured to supply a continuous steady-state current to the cathode, wherein the cathode power supply comprises: an isolation transformer, a rectifier circuit and a filter circuit.

12. The microwave source according to claim 11, wherein the cathode comprises a cooling apparatus configured to cool the rectifier circuit, the filter circuit and the cathode.

13. The microwave source according to claim 10, wherein

the microwave transmission line comprises: an excitation cavity, a circulator, a direct current blocker, a ceramic window, an antenna that are sequentially connected, and a water load connected to the circulator; and a directional coupler is connected to at least one of: a position between the excitation cavity and the circulator, a position between the direct current blocker and the ceramic window, and a position between the circulator and the water load.

14. A microwave heating system, comprising:
the microwave source according to any one of claims 10 to 13, wherein the microwave source is configured to couple plasma in a thermonuclear reaction apparatus to heat the plasma.

Marx generator 110

Marx module 111

1111

Drive module 1113

All-solid-state switch 1112

● ● ●

Marx module 111

Charging circuit 120

Control system 130

FIG. 1

D+

1114

1111

Drive module 1113

Q

GND

D-

FIG. 2

FIG. 3

FIG. 4

FIG. 5

FIG. 6

FIG. 7

FIG. 8

FIG. 9

FIG. 10

## INTERNATIONAL SEARCH REPORT

| International application No. |
|---|
| **PCT/CN2023/133018** |

### A. CLASSIFICATION OF SUBJECT MATTER

H03K3/57(2006.01)i

According to International Patent Classification (IPC) or to both national classification and IPC

### B. FIELDS SEARCHED

Minimum documentation searched (classification system followed by classification symbols)

IPC:H03K3/-,H02M3/-

Documentation searched other than minimum documentation to the extent that such documents are included in the fields searched

Electronic data base consulted during the international search (name of data base and, where practicable, search terms used)

CNABS, CNTXT, CNKI, VEN, CDFJ: 高压电源, 马克斯发生器, 储能电容, 串联, 全固态开关, 驱动, 充电, 放电, 二极管, 触发信号, 监测, 微波源, 微波振荡, 整流, 滤波, 阴极, 冷却, 激励腔, 定向耦合器, 加热系统, 等离子体, high voltage power supply, Marx generator, capacitor? , series, switch+, IGBT, driv+, charg+, discharge+, diode? , trigger signal, monitor +, microwave source, microwave oscillation, rectification, filtering, cathode, cooling, excitation cavity, directional coupler, heat +, plasma

### C. DOCUMENTS CONSIDERED TO BE RELEVANT

| Category* | Citation of document, with indication, where appropriate, of the relevant passages | Relevant to claim No. |
|---|---|---|
| X | CN 115967374 A (CHONGQING UNIVERSITY) 14 April 2023 (2023-04-14) <br> see description, paragraphs 45-122, and figures 1-5 | 1-14 |
| X | US 2014077619 A1 (TSINGHUA UNIVERSITY et al.) 20 March 2014 (2014-03-20) <br> description, paragraphs 18-38, and figures 1-5 | 1-14 |
| A | CN 102441231 A (CHONGQING UNIVERSITY) 09 May 2012 (2012-05-09) <br> entire document | 1-14 |
| A | DE 102004001782 A1 (KERN, M.) 11 August 2005 (2005-08-11) <br> entire document | 1-14 |
| A | KR 101810793 B1 (HANWHA CORP.) 19 December 2017 (2017-12-19) <br> entire document | 1-14 |
| A | KR 20090002714 A (KOREA ELECTRO TECHNOLOGY RESEARCH INSTITUTE) 09 January 2009 (2009-01-09) <br> entire document | 1-14 |

☑ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **18 April 2024** | **19 April 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**EP 4 757 182 A1**

## INTERNATIONAL SEARCH REPORT

| | International application No. |
|---|---|
| | **PCT/CN2023/133018** |

**C.     DOCUMENTS CONSIDERED TO BE RELEVANT**

| Category* | Citation of document, with indication, where appropriate, of the relevant passages | Relevant to claim No. |
|---|---|---|
| A | US 2006139977 A1 (KAISER SYSTEMS INC.) 29 June 2006 (2006-06-29)<br>entire document | 1-14 |
| A | US 2018367125 A1 (STANGENES INDUSTRIES, INC.) 20 December 2018 (2018-12-20)<br>entire document | 1-14 |

Form PCT/ISA/210 (second sheet) (July 2022)

## INTERNATIONAL SEARCH REPORT
### Information on patent family members

International application No.

**PCT/CN2023/133018**

| Patent document cited in search report | | | Publication date (day/month/year) | Patent family member(s) | | | Publication date (day/month/year) |
|---|---|---|---|---|---|---|---|
| CN | 115967374 | A | 14 April 2023 | None | | | |
| US | 2014077619 | A1 | 20 March 2014 | US | 9843313 | B2 | 12 December 2017 |
| | | | | JP | 2015507912 | A | 12 March 2015 |
| | | | | JP | 6031532 | B2 | 24 November 2016 |
| | | | | EP | 2800267 | A1 | 05 November 2014 |
| | | | | EP | 2800267 | A4 | 29 June 2016 |
| | | | | EP | 2800267 | B1 | 09 February 2022 |
| | | | | WO | 2013097299 | A1 | 04 July 2013 |
| | | | | KR | 20140119694 | A | 10 October 2014 |
| | | | | KR | 101613537 | B1 | 19 April 2016 |
| CN | 102441231 | A | 09 May 2012 | None | | | |
| DE | 102004001782 | A1 | 11 August 2005 | None | | | |
| KR | 101810793 | B1 | 19 December 2017 | None | | | |
| KR | 20090002714 | A | 09 January 2009 | KR | 100931844 | B1 | 15 December 2009 |
| US | 2006139977 | A1 | 29 June 2006 | WO | 2006071886 | A2 | 06 July 2006 |
| | | | | WO | 2006071886 | A9 | 17 August 2006 |
| | | | | WO | 2006071886 | A3 | 07 December 2006 |
| | | | | US | 7209373 | B2 | 24 April 2007 |
| US | 2018367125 | A1 | 20 December 2018 | JP | 2020524470 | A | 13 August 2020 |
| | | | | JP | 6948413 | B2 | 13 October 2021 |
| | | | | US | 10855262 | B2 | 01 December 2020 |
| | | | | EP | 3635866 | A1 | 15 April 2020 |
| | | | | EP | 3635866 | B1 | 07 April 2021 |
| | | | | WO | 2018236883 | A1 | 27 December 2018 |
| | | | | WO | 2018236883 | A8 | 04 July 2019 |

Form PCT/ISA/210 (patent family annex) (July 2022)